# EUROPEAN PATENT SPECIFICATION

(11) **EP 2 523 344 B1**
(45) Date of publication and mention of the grant of the patent: **12.11.2014**
(21) Application number: 11290224.2
(22) Date of filing: 12.05.2011
(51) Int. Cl.: H03F 3/191, H03F 3/217, H03F 3/68

(54) **Device and method to amplify a digital multibit signal**
Vorrichtung und Verfahren zur Verstärkung eines digitalen Multibit-Signals
Dispositif et procédé pour l'amplification d'un signal numérique multibit

(43) Date of publication of application: 14.11.2012
(73) Proprietor: ALCATEL LUCENT, 92100 Boulogne-Billancourt (FR)
(72) Inventor: Dartois, Luc, 91620 Nozay (FR)
(74) Representative: Croonenbroek, Thomas Jakob

(56) References cited:
- WO-A2-2004/034603
- US-B2- 6 819 171
- SEAH K-H ET AL: "Digital polar transmitter for ultra-wideband system using OFDM modulation", ELECTRONICS LETTERS, IEE STEVENAGE, GB, vol. 43, no. 8, 12 April 2007 (2007-04-12) , pages 466-468, XP006028478, ISSN: 0013-5194, DOI: DOI:10.1049/EL:20070126
- CHOWDHURY D ET AL: "A 2.4GHz mixed-signal polar power amplifier with low-power integrated filtering in 65nm CMOS", CUSTOM INTEGRATED CIRCUITS CONFERENCE (CICC), 2010 IEEE, IEEE, PISCATAWAY, NJ, USA, 19 September 2010 (2010-09-19), pages 1-4, XP031786643, ISBN: 978-1-4244-5758-8
- PAUL T M VAN ZEIJL ET AL: "The theoretical efficiency in digital envelope power amplifiers for WLAN OFDM polar transmitters", IEEE INTERNATIONAL SYMPOSIUM ON CIRCUITS AND SYSTEMS. ISCAS 2010 - 30 MAY-2 JUNE 2010 - PARIS, FRANCE, IEEE, US, 30 May 2010 (2010-05-30), pages 1105-1108, XP031724567, ISBN: 978-1-4244-5308-5
- TABRIZI M M ET AL: "A New Topology for Power Control of High Efficiency Class-E", IEEE-NEWCAS CONFERENCE, 2005. THE 3RD INTERNATIONAL QUEBEC CITY, CANADA 19-22 JUNE, 2005, PISCATAWAY, NJ, USA,IEEE, 19 June 2005 (2005-06-19), pages 348-351, XP010828327, DOI: DOI:10.1109/NEWCAS.2005.1496744 ISBN: 978-0-7803-8934-2
- PRESTI C D ET AL: "A 25 dBm Digitally Modulated CMOS Power Amplifier for WCDMA/EDGE/OFDM With Adaptive Digital Predistortion and Efficient Power Control", IEEE JOURNAL OF SOLID-STATE CIRCUITS, IEEE SERVICE CENTER, PISCATAWAY, NJ, USA, vol. 44, no. 7, 1 July 2009 (2009-07-01), pages 1883-1896, XP011263253, ISSN: 0018-9200, DOI: DOI:10.1109/JSSC.2009.2020226

## Description

### BACKGROUND OF THE INVENTION

The present invention relates to the field of telecommunications and more specifically of amplifying a digital signal in a wireless radio access network communication.

The amplification, or power amplification is the step before the emission in transmitters, wherein the digital signal coming from the digital hardware is converted in an analogue signal and amplified at a power level sufficient to be fed to an antenna.

It is known to use sigma-delta modulation means to operate the conversion from digital to analogue. In said modulation means, the signal is usually oversampled from a factor greater than two, often around ten or above. With signals at original sampling rates of hundreds of MHz (like in telecommunications), this means that the oversampled signal has a rate of several GHz.

It is known to use multibit sigma delta signals to improve quantization and signal spectrum quality, in which the signal is divided in parallel lines of single bit streams, to allow such signal rates to be put through. An example can be derived from the multi-branch Dohcrty structure, where each branch has its own driver and amplifier, all delivering their output to a linear combiner.

With such multibit signals in parallel lines or branches, the problem arises that the different independent components have different intrinsic non-linear behaviours inducing errors at the reconstruction of the signal, due for example to different delays while going through the branches, or different gain values in amplifiers. Moreover, the combiners also often induce non-linearities leading to signal deterioration.

Digital, binary-weighted RF power amplifiers are known from US 6819171, WO2004/034603, and from the papers:
'Digital polar transmitter for ultra-wideband system using OFDM modulation', by Seah K-H; Chia M Y-W; Papavassiliou C; Constantinides G A, ELECTRONICS LETTERS, IEE STEVENAGE, GB, 2007-04-12, ISSN 0013-5194 XP006028478;
'A 2.4GHz mixed-signal polar power amplifier with low-power integrated filtering in 65nm CMOS', by Chowdhury D; Lu Ye; Alon E; Niknejad A M, Custom Integrated Circuits Conference (CICC), 2010 IEEE, Piscataway, NJ, USA, 2010-09-19, ISBN 978-1-4244-5758-8, ISBN 1-4244-5758-0, XP031786643;
'The theoretical efficiency in digital envelope power amplifiers for WLAN OFDM polar transmitters', by Paul T M van Zeijl; Manel Collados, IEEE International Symposium on Circuits and Systems. ISCAS 2010 - 30 May-2 June 2010 - Paris, France, ISBN 978-1-4244-5308-5, ISBN 1-4244-5308-9, XP031724567;
'A New Topology for Power Control of High Efficiency Class-E', by Tabrizi M M; Masoumi N; Aghnout S, IEEE-NEWCAS Conference, 2005. The 3rd International Quebec City, Canada 19-22 June, 2005, IEEE, Piscataway, NJ, USA, 2005-06-19, XP010828327;
'A 25 dBm Digitally Modulated CMOS Power Amplifier for WCDMA/EDGE/OFDM With Adaptive Digital Predistortion and Efficient Power Control', by Presti C D; Carrara F; Scuderi A; Asbeck P M; Palmisano G, IEEE JOURNAL OF SOLID-STATE CIRCUITS, 20090701, IEEE SERVICE CENTER, PISCATAWAY, NJ, USA, XP011263253.

### SUMMARY OF THE INVENTION

In order to overcome at least partially the aforementioned drawbacks, the invention has for object a power amplification device to amplify a digital multibit stream encoded on a plurality of single bit streams, comprising a plurality of two state amplifiers connected respectively to one single bit stream, wherein :
- the two state amplifiers are configured to deliver in their high state an output proportional to a weight chosen so that the sum of the weights of the emitting power amplifiers in high state for each multibit value is different from the sum of the weights of the emitting power amplifiers for the other multibit values,
- the output of the amplifiers is connected to a combining stage, configured to sum the output of the amplifiers to obtain the amplified signal.

By giving in output an amplified signal having only a finite number of possible values, the transmission impairments are easier to correct. Moreover, the relative weights are an additional degree of freedom to perform error reduction.

It comprises a multiplexing unit configured to multiplex a plurality of least significant bits on the bit stream connected to the lowest weight power amplifier.

The power amplification device can also have one or more of the following characteristics, considered separately or in combination.

The most significant bit is encoded on the bit stream connected to the highest weight power amplifier.

The least significant bit is encoded on the bit stream connected to the lowest weight power amplifier.

The two state amplifiers comprise elementary transistors of a transistor die, connected in parallel in the respective branches in relative numbers corresponding to the weight values of the branches.

The fingers corresponding to one elementary transistor of the amplification transistor die are respectively bound to at least one driver, wherein said drivers are elementary transistors of a driver transistor die, and wherein the binding is obtained by connecting at least one finger of the driver transistor die to one finger of the amplification transistor die with respective lines.

Inverted lines are associated to the lines connecting fingers of the driver transistor die with fingers of the amplification transistor die, wherein said lines are fed with an inverted signal, and wherein the connecting lines and inverted lines end in a class S amplifier.

It further comprises finite impulse response (FIR) filters, configured to filter the signal of the respective branches.

The device comprises a feedback loop configured to adapt the weight of at least one power amplifier to counterbalance the distortion in the output signal.

The power amplifiers are connected to respective delay lines to uncouple their respective signals.

Another object of the invention is the associated method to amplify a digital multibit stream encoded on a plurality of bit streams, with the steps :
- the bit streams are fed to independent two state power amplification chains,
- the respective power amplification chains amplify the bit streams in a high power amplified analogue signal, with a power proportional to a relative weight of the power amplification chain chosen so that the sum of the weights of the emitting power amplification chains for each multibit value is different from the sum of the weights of the emitting power amplification chains for the other multibit stream values,
- the digital signals in output of the power amplification chains is combined to obtain the amplified analogue output signal.

A plurality of least significant bits is multiplexed on the bit stream connected to the lowest weight power amplification chain.

The method can also have one or more of the following characteristics, considered separately or in combination.

It further comprises the step :
- the relative weight value of at least one amplification chain is adjusted by design according to the power distortion measured in output.

The highest weight power amplification chain encodes the most significant bit.

The lowest weight power amplification chain encodes the least significant bit.

Further characteristics of the invention will appear at the reading of the following description, describing by way of example different embodiments with reference to the accompanying drawings, in which :
- Fig. 1 represents schematically one example of an amplification device,
- Fig. 2 represents schematically an embodiment of the amplification device according to the invention,
- Fig 3 depicts the steps of one embodiment of the associated method to amplify a digital multibit signal.

In all figures the same references relate to the same elements.

### DETAILED DESCRIPTION OF THE INVENTION

The invention relates to a power amplification device in a transmitter, more particularly in a radio telecommunication network, such as a wireless radio access network.

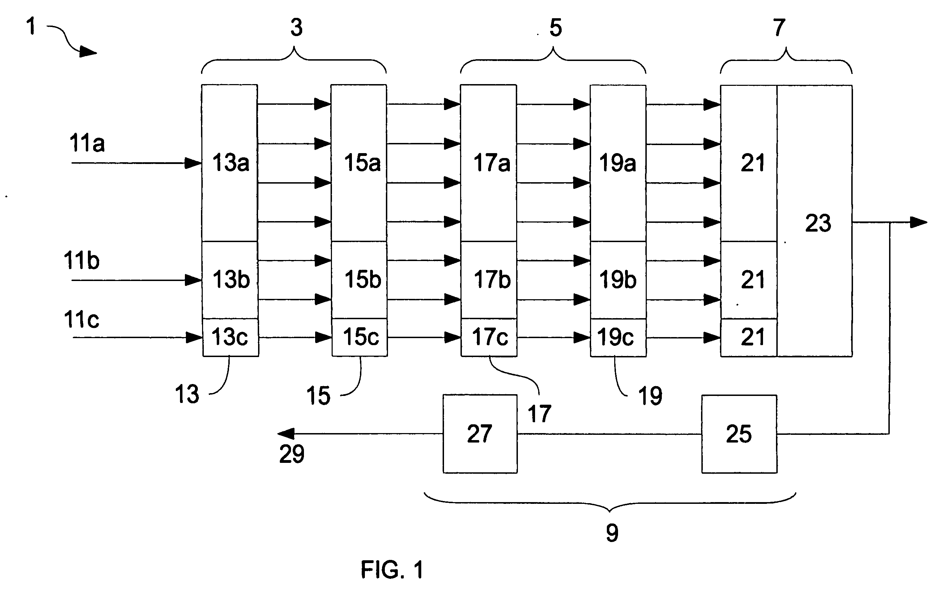

Figure 1 represents a power amplification device 1.

The power amplification device 1 comprises a driver stage 3, a power amplification stage 5 and a filtering and combining stage 7. Said stages 3, 5, 7 are mounted in series, and a feedback loop 9 is connected to the output of final filtering and combining stage 7.

The driver stage 3 receives in input three single streams 11 a, 11b, 11 c of a multibit stream comprising in this particular case three bits. The invention can be applied to a multibit stream of any size. In its global architecture, the power amplification device 1 follows this three-way architecture, with a structure comprising three branches, and components on specific branches will be labelled with an a, b or c according to the branch they belong to.

The different branches arc attributed a relative weight, and give when in high amplification state a signal proportional to their weight. In this case the three branches are attributed respective weights about 4, 2 and 1..

The series of powers of two (2^{N}) is used herein, from 2⁰ to 2². In a general case with a N bit stream and N branches, one can use the approximate weight values reaching from 2⁰ = 1 to 2^{N-1}.

The driver stage 3 comprises a driver transistor die 13, followed by a driver drain bias network 15. The driver transistor die 13 is divided in three portions 13a, 13b, 13c, associated to a respective branch of the device 1. The driver drain network 15 is divided in three portions 15a, 15b, 15c, associated to a respective branch of the device 1.

The output of the driver stage 3 is fed to the power amplification stage 5. The power amplification stage 5 comprises a power amplification gate network 17, followed by a power amplification transistor die 19. The power amplification gate network 17 is divided in three portions 17a, 17b, 17c, associated to a respective branch of the device 1. The power amplification transistor die 19 is divided in three portions 19a, 19b, 19c, associated to a respective branch of the device 1 and working in two amplification states high and low, like a class S amplifier.

To obtain the relative weights, the different portions 13a, 13b, 13c of the driver transistor die 13 and the different portions 19a, 19b, 19c of the power amplification transistor die 19 can comprise a number of elementary transistors that is proportional to the desired weight of the branch they arc associated to. This is simply obtained by binding together the fingers of the die 13, 19 corresponding to the elementary transistors of the die 13, 19. This is shown on figure 1 by picturing parallel lines in a number proportional to the weight for the signal lines between the components, in this case 4, 2 and 1 lines respectively for the three respective branches.

By doing so, it is ensured that when activating a specific branch, a number of parallel elementary transistors proportional to the weight of said branch is activated.

Moreover having all along the driver chain a proportionally higher number of elementary driver chains for higher weight branches ensures that each elementary driver and driver transistor is feeding same size of last stage with similar input capacitance load.

Consequently for each weight one can have the same number of driver/pre amplification stages per branch a, b, c and ensure at those high speeds that each branch has same delay and each bitstream has same rise/fall time for the last stage recombination. This is critical for the accuracy of signal reconstruction and spectral quality at amplification device 1 output, especially with most used types of last stage transistor dies 19 that have large gate input capacitance like LDMOS or GaN technologies.

The output of the power amplification stage 5 is sent to the filtering and combination stage 7. The filtering and combining stage comprises a plurality of combiners 21 a, 21b, 21c, one per branch, that are usually a combination of die fingers signal current additionners implemented after class S transistors.

Each branch resulting weighted current is then combined and filtered in final combiner and filter 23.

Combining is usually done with a network of delay and adapting striplines whose function is to limit load modulation effect between branches. The combined signal is comparable with other switched mode power amplifiers with sigma delta generated signal, filtered by so called reconstruction filters aiming at removing wideband sigma delta noise to retrieve narrow band wanted signal with its native envelope modulation.

The following correspondence is then obtained between the three bit input value and the analogue amplified output value :

| | | |
|---|---|---|
| 000 | 0 | |
| 001 | 1 | (2⁰) |
| 010 | 2 | (2¹) |
| 011 | 3 | (2⁰ + 2¹) |
| 100 | 4 | (2²) |
| 101 | 5 | (2⁰ + 2²) |
| 110 | 6 | (2¹+2²) |
| 111 | 7 | (2⁰+2¹ + 2²) |

This shows that the power amplification device 1 works "as if it were" a digital to analogue converter.

Since the amplification device 1 delivers in output a signal with a finite number of states, as opposed to analog amplifiers, errors are attached to each or some of the states mainly due to either uneven matching between weights in transistors 13, 19 and load modulation effects in the branches signal recombination. Due to small number of states and wide native bandwidth of transistors 13, 19, there is much less memory effect and the number of errors and combination of errors is limited mainly to the number of states of the amplification device 1.

To enhance overall signal robustness, the most significant bit (MSB) stream is connected to the highest weight amplifier 19a. The least significant bit (LSB) stream is connected to the lowest weight amplifier 19c. Moreover, the weight of the most significant bit stream amplifier 19a can be emphasized to be more easily detected in the signal. In the example, it would be a weight of, for instance, five instead of four.

A feedback loop 9 is connected to the final output. As depicted on figure 1, it comprises a sampling unit 25, taking samples of the output, and a predistortion and amplitude and phase modulation calibration unit 27. The feedback loop provides a feedback signal 29, used to adjust predistortion. The feedback signal can be used to change indirectly the weight values of the branches in the signal generator, for example by taking into account in a non linear stigma delta generator the 2^{N} states constellation.

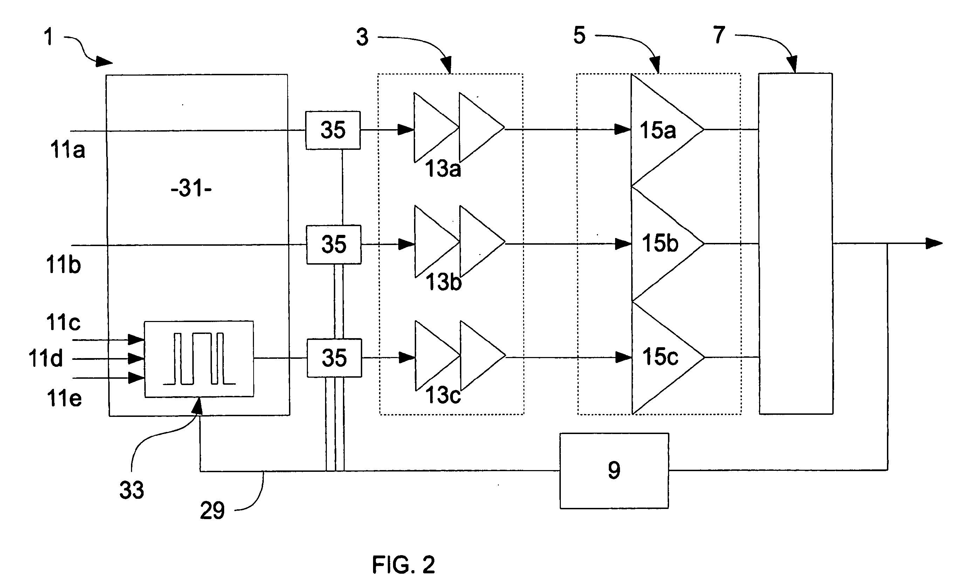

Figure 2 is a schematic view of an embodiment of the invention. On figure 2 the amplification device 1 works with a 5 bit stream. The five single streams 11a to 11e are connected to a very high speed digital signal generator, like a field programmable gate array (FPGA) 31 or an application specific integrated circuit (ASIC). Said field programmable gate array 31 also receives the feedback signal 29 from the feedback loop, and adapts predistortion tables using said signal 29.

The field programmable gate array 31 also comprises a multiplexing unit 33, configured to multiplex the three least significant bits 11c, 11d, 11e in one single stream using, in this example, pulse-width modulation. For each combination of bits a different pulse is generated. Pulse width is proportional to the value represented by the 3 bits word 11c, 11d and 11e and can take eight widths : 0, 1/7, 2/7,up to 7/7 of the period of all the bitstreams 11c, 11 d, 11 e, and centred on the middle of the bitstream period.

The output of FPGA 31 is also a three line signal, and on the lines are respectively placed delay lines 35, controlled by the feedback loop 9 to adjust the impairments between the branches. By adjusting the impairments in weights and group delay, compensation can be pre-compensated to retrieve spectrum quality of the native signal to amplify..

The rest of the architecture is similar to that of amplification device 1 of figure 1, with a driver stage 3, comprising one driver 13a, 13b, 13c per branch, an amplification stage 5, comprising one amplifier 19a, 19b, 19c per branch, and a filtering and combination stage 7.

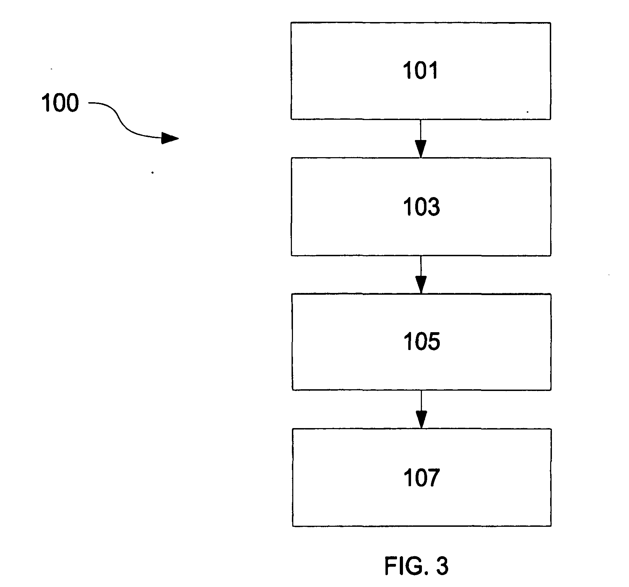

Figure 3 shows the steps of one embodiment of the associated method 100 to amplify a digital multibit signal.

In first step 101 the single bit streams arc fed to independent two state power amplification chains.

In step 103 the respective power amplification chains amplify the bit streams in a high power amplified analogue signal. The amplification chains deliver an analogue output signal with a power proportional to a relative weight of the power amplification chain chosen so that the sum of the weights of the emitting power amplification chains for each multibit value is different from the sum of the weights of the emitting power amplification chains for the other multibit stream values.

In step 105, the digital signal in output of the power amplification chains is combined to obtain the amplified analogue output signal.

Step 107 is an adjusting step, in which the feedback loop 9 is used to adjust to modify over time the usage ratio of the different weights, as the weight ratio between branches a, b, c cannot be changed on a given hardware due to binary nature of the bitstreams 11 a, 11b, 11c.

A variant, aiming at improving regularity of the design and time alignment between upper and and lower weight driver branches a, b, c, consists in providing respective dedicated drivers 13 for the single fingers corresponding to elementary branches connected to one respective elementary transistor of the amplifier die 19. Doing so, the different fingers of said die 19 have the same input capacitance and need same size of driver 13 and consequently same driver power to be generated and it can be done with exactly same and reduced number of driver stages 13 in each branch a, b, c which is important to maintain good signal slew rates and rise/fall time alignment between branches a, b, c to have all fingers of last stage to switch at same time. This just requires to have in the signal generator the means for generating in phase exact replica of bitstream 11a, 11b of higher weights. This can easily be done by binding respectively one finger of the amplification die 19 with one finger of the driver die 13.

A further improvement consists in obtaining a class S power amplifier using a known balun (balanced/unbalanced) output combiner to sum a normal and "inverted" branch. Said inverted branch is an additional, parallel branch associated respectively to the branch destined to end in said class S power amplifier. The inverted branch is fed with a signal similar to the one it is associated to, but inverted.

It can preferably use a twice bigger last stage transistor 19 with twice more fingers, half of them being fed by a normal driver, while the other half is fed by an inverted driver. This ensures good power balancing between each weight contributor and its invert as using fingers of same die 19, therefore with good accuracy in having same gain, current and S parameters.

A last improvement consist in an additional step of sharing same last stage die while multiplying accordingly the number of elementary fingers and driver elementary transistors of driver transistor die 13 in parallel. As switch mode power amplifiers are fed with multibit sigma delta or PWM signals, the amplified signal is quite noisy outside the useful bandwidth and needs a so called reconstruction filter to reduce said noise. Most critical noise is the one rising close to the useful band and where too sharp analog reconstruction filter would have extra losses destroying part of switch mode power amplifier high efficiency advantages.

The idea is to use binary parsed digital finite impulse response (FIR) filters having the advantage of unitary signed coefficients that correspond to delaying and inverting or not the native signal. This can easily be done in the digital replica of signal bitstreams 11a, 11b, 11c.

For example with five taps filter one can filter 10-12dB of noise at distance of 100MHz of carrier for a 2GHz RF carrier. In such example it would need five times more elementary drivers on replica of each weight and bitstream 11a, 11b, 11c.

A three bit signal (three binary weighted branches in the power amplifier) in balanced class S would then have 5*2*(4+2+1)=70 elementary drivers in parallel and 70 elementary fingers in last stage.

In LDMOS a basic finger is 0,4mm gate length for power density of <1 watt per mm of gate. So 70 fingers correspond to a medium power transistor of 30W peak power. A large transistor can have about 4 times more fingers.

By giving in output a signal with a finite number of values, the amplification device 1 allows a better signal robustness. Moreover, two-state amplifiers 19a, 19b, 19c are used. Such amplifiers have a better power efficiency than non constant envelope amplifiers who linearly amplify the envelope of a signal. The branch architecture allows to selectively power down statistically one or more branches when low traffic is expected. The amplification device 1 can thus have a reduced overall power consumption.

Also, the device 1 has a simple architecture, since no digital to analogue conversion stage and radio modulation stage are required. As explained, the multi-branch architecture is easily obtained by using the parallel transistor architecture in the already existing dies, and the weights are obtained by simply binding fingers of said dies. The obtained amplification device is compact, simple and accordingly cheap. Moreover, it is compatible with already existing transmitter architectures.

## Claims

1. Power amplification device to amplify a digital multibit stream encoded on a plurality of single bit streams, comprising a plurality of two state amplifiers (19a, 19b, 19c) connected respectively to one single bit stream (11a, 11b, 11c), wherein :
- the two state amplifiers (19a, 19b, 19c) are configured to deliver in their high state an output proportional to a weight chosen so that the sum of the weights of the emitting power amplifiers in high state for each multibit value is different from the sum of the weights of the emitting power amplifiers (19a, 19b, 19c) for the other multibit values,
- the output of the amplifiers is connected to a combining stage (7), configured to sum the output of the amplifiers (19a, 19b, 19c) to obtain the amplified signal,
**characterized in that** the power amplification device further comprises a multiplexing unit (33) configured to multiplex a plurality of least significant bits on the bit stream connected to the lowest weight power amplifier (19c).

2. Power amplification device according to claim 1 or 2, wherein the most significant bit is encoded on the bit stream connected to the highest weight power amplifier (19a).

3. Power amplification device according to claim 1, 2 or 3, wherein the least significant bit is encoded on the bit stream connected to the lowest weight power amplifier (19c).

4. Power amplification device according to any of the precedent claims, wherein the two state amplifiers (19a, 19b, 19c) comprise elementary transistors of a transistor die (19), connected in parallel in the respective branches (a, b, c) in relative numbers corresponding to the weight values of the branches (a, b, c).

5. Power amplification device according to claim 4, wherein the fingers corresponding to one elementary transistor of the amplification transistor die (19) are respectively bound to at least one driver, wherein said drivers are elementary transistors of a driver transistor die (13), and wherein the binding is obtained by connecting at least one finger of the driver transistor die (13) to one finger of the amplification transistor die (19) with respective lines.

6. Power amplification device according to any of claims 4 or 5, wherein inverted lines are associated to the lines connecting fingers of the driver transistor die (13) with fingers of the amplification transistor die (19), wherein said lines are fed with an inverted signal, and wherein the connecting lines and inverted lines end in a class S amplifier.

7. Power amplification device according to any of claims 4 to 6, further comprising finite impulse response (FIR) filters, configured to filter the signal of the respective branches (a, b, c).

8. Power amplification device according to any of claims 1 to 7, further comprising a feedback loop (9) configured to adapt the weight of at least one power amplifier (19a, 19b, 19c) to counterbalance the distortion in the output signal.

9. Power amplification device according to any of claims 1 to 6, wherein the power amplifiers (19a, 19b, 19c) are connected to respective delay lines (35) to uncouple their respective signals.

10. Method to amplify a digital multibit stream encoded on a plurality of bit streams, with the steps :
- the bit streams are fed to independent two state power amplification chains,
- a plurality of least significant bits (LSB) is multiplexed on the bit stream connected to the lowest weight power amplification chain,
- the respective power amplification chains amplify the bit streams in a high power amplified analogue signal, with a power proportional to a relative weight of the power amplification chain chosen so that the sum of the weights of the emitting power amplification chains for each multibit value is different from the sum of the weights of the emitting power amplification chains for the other multibit stream values,
- the digital signals in output of the power amplification chains are combined to obtain the amplified analogue output signal.

11. Method according to claim 10, further comprising the step :
- the relative weight value of at least one amplification chain is adjusted by design according to the power distortion measured in output.

12. Method according to claim 10 or 11, wherein the highest weight power amplification chain encodes the most significant bit (MSB).

13. Method according to any of the claims 10 to 12, wherein the lowest weight power amplification chain encodes the least significant bit (LSB).

## Patentansprüche

1. Leistungsverstärkungsvorrichtung zur Verstärkung eines auf einer Vielzahl von Einbit-Datenströmen codierten digitalen Mehrbit-Datenstroms, umfassend eine Vielzahl von Zweizustands-Verstärkern (19a, 19b, 19c), welche jeweils mit einem Einbit-Datenstrom (11a, 11b, 11c) verbunden sind, wobei:
- Die Zweizustands-Verstärker (19a, 19b, 19c) dafür konfiguriert sind, in ihrem "High"-Zustand eine Ausgabe zu liefern, die proportional zu einer Gewichtung ist, welche derart gewählt wird, dass sich die Summe der Gewichtungen der emittierenden Leistungsverstärker im "High"-Zustand für jeden Mehrbit-Wert von der Summe der Gewichtungen der emittierenden Leistungsverstärker (19a, 19b, 19c) für die anderen Mehrbit-Werte unterscheidet,
- der Ausgang der Verstärker an eine Kombinierungsstufe (7) angeschlossen ist, welche dafür konfiguriert ist, die Ausgabe der Verstärker (19a, 19b, 19c) zu summieren, um das verstärkte Signal zu erhalten,
**dadurch gekennzeichnet, dass** die Leistungsverstärkungsvorrichtung weiterhin eine Multiplex-Einheit (33) umfasst, welche für das Multiplexen einer Vielzahl von niedrigstwertigen Bits auf dem mit dem Leistungsverstärker mit der niedrigsten Gewichtung (19c) verbundenen Bitstrom konfiguriert ist.

2. Leistungsverstärkungsvorrichtung nach Anspruch 1 oder 2, wobei das höchstwertige Bit auf dem mit dem Leistungsverstärker mit der höchsten Gewichtung (19a) verbundenen Bitstrom codiert wird.

3. Leistungsverstärkungsvorrichtung nach Anspruch 1, 2 oder 3, wobei das niedrigstwertige Bit auf dem mit dem Leistungsverstärker mit der niedrigsten Gewichtung (19c) verbundenen Bitstrom codiert wird.

4. Leistungsverstärkungsvorrichtung nach einem beliebigen der vorstehenden Ansprüche, wobei die Zweizustands-Verstärker (19a, 19b, 19c) Etementartransistoren eines Transistorwürfels (19) umfassen, die in den jeweiligen Abzweigungen (a; b, c) in relativen Anzahlen, welche den Gewichtungswerten der Abzweigungen (a, b, c) entsprechen, parallel angeschlossen sind.

5. Leistungsverstärkungsvorrichtung nach Anspruch 4, wobei die einem Elementartransistor des Verstärkungstransistorwürfels (19) entsprechenden Finger jeweils an mindestens einen Treiber gebunden sind, wobei die besagten Treiber Elementartransistoren eines Treibertransistorwürfels (13) sind, und wobei die Bindung durch Anschließen mindestens eines Fingers des Treibertransistorwürfels (13) an einen Finger des Verstärkungstransistorwürfels (19) mit jeweiligen Leitungen erreicht wird.

6. Leistungsverstärkungsvorrichtung nach einem beliebigen der Ansprüche 4 oder 5, wobei inverse Leitungen mit den Leitungen, welche die Finger des Treibertransistorwürfels (13) mit Fingern des Verstärkungstransistorwürfels (19) verbinden, assoziiert sind, wobei ein inverses Signal in die besagten Leitungen eingespeist wird, und wobei die Verbindungsleitungen und die inversen Leitungen in einem Klasse S-Verstärker enden.

7. Leistungsverstärkungsvorrichtung nach einem beliebigen der Ansprüche 4 bis 6, weiterhin umfassend Filter mit endlicher Impulsantwort (FIR), welche für das Filtern des Signals der jeweiligen Abzweigungen (a, b, c) konfiguriert sind.

8. Leistungsverstärkungsvorrichtung nach einem beliebigen der Ansprüche 1 bis 7, weiterhin umfassend eine Rückkopplungsschleife (9), welche für das Anpassen der Gewichtung mindestens eines Leistungsverstärkers (19a, 19b, 19) konfiguriert ist, um die Verzerrung in dem Ausgangssignal auszugleichen.

9. Leistungsverstärkungsvorrichtung nach einem beliebigen der Ansprüche 1 bis 6, wobei die Leistungsverstärker (19a, 19b, 19c) an jeweilige Verzögerungsleitungen (35) angeschlossen sind, um deren jeweiligen Signale abzukoppeln.

10. Verfahren zur Verstärkung eines auf einer Vielzahl von Einbit-Datenströmen codierten digitalen Mehrbit-Datenstroms, die folgenden Schritte umfassend:
- Einspeisen der Bitströme in unabhängige Zweizustands-Verstärkerketten,
- Multiplexen einer Vielzahl von niedrigstwertigen Bits (LSB) auf den mit der Leistungsverstärkerkette mit der niedrigsten Gewichtung verbundenen Bitstrom,
- Verstärken, in den jeweiligen Leistungsverstärkerketten, der Bitströme zu einem verstärkten analogen Hochleistungssignal, wobei die Leistung proportional zu einer relativen Gewichtung der Leistungsverstärkerkette ist, welche derart gewählt wird, dass sich die Summe der Gewichtungen der emittierenden Leistungsverstärkerketten für jeden Mehrbit-Wert von der Summe der Gewichtungen der emittierenden Leistungsverstärkerketten für die anderen Mehrbit-Datenstromwerte unterscheidet,
- Kombinieren der digitalen Signale in der Ausgabe der Leistungsverstärkerketten, um das verstärkte analoge Ausgangssignal zu erhalten.

11. Verfahren nach Anspruch 10, weiterhin folgenden Schritt umfassend:
- Anpassen des Wertes der relativen Gewichtung mindestens einer Verstärkerkette je nach Ausführung entsprechend der am Ausgang gemessenen Leistungsverzerrung.

12. Verfahren nach Anspruch 10 oder 11, wobei die Leistungsverstärkerkette mit der höchsten Gewichtung das höchstwertige Bit (MSB) codiert.

13. Verfahren nach einem beliebigen der Ansprüche 10 bis 12, wobei die Leistungsverstärkerkette mit der niedrigsten Gewichtung das niedrigstwertige Bit (LSB) codiert.

## Revendications

1. Dispositif d'amplification de puissance pour amplifier un flux multibit numérique codé sur une pluralité de flux de bits uniques, comprenant une pluralité d'amplificateurs bistables (19a, 19b, 19c) connectés respectivement à un flux de bits unique (11a, 11 b, 11 c), dans lequel
- les amplificateurs bistables (19a, 19b, 19c) sont configurés pour délivrer dans leur état haut une sortie proportionnelle à un poids choisi de sorte que la somme des poids des amplificateurs de puissance d'émission à l'état haut pour chaque valeur multibit soit différente de la somme des poids des amplificateurs de puissance d'émission (19a, 19b, 19c) pour les autres valeurs multibit,
- la sortie des amplificateurs est connectée à un étage de combinaison (7), configuré pour additionner la sortie des amplificateurs (19a, 19b, 19c) pour obtenir le signal amplifié,
**caractérisé en ce que** le dispositif d'amplification de puissance comprend en outre une unité de multiplexage (33) configurée pour multiplexer une pluralité de bits de poids le plus faible sur le flux de bits connecté à l'amplificateur de puissance de poids le plus faible (19c).

2. Dispositif d'amplification de puissance selon la revendication 1 ou 2, dans lequel le bit de poids le plus fort est codé sur le flux de bits connecté à l'amplificateur de puissance de poids le plus fort (19a).

3. Dispositif d'amplification de puissance selon la revendication 1, 2 ou 3, dans lequel le bit de poids le plus faible est codé sur le flux de bits connecté à l'amplificateur de puissance de poids le plus faible (19c).

4. Dispositif d'amplification de puissance selon l'une quelconque des revendications précédentes, dans lequel les amplificateurs bistables (19a, 19b, 19c) comprennent des transistors élémentaires d'une matrice de transistor (19), connectés en parallèle dans les branches respectives (a, b, c) en nombres relatifs correspondant aux valeurs de poids des branches (a, b, c).

5. Dispositif d'amplification de puissance selon la revendication 4, dans lequel les doigts correspondant à un transistor élémentaire de la matrice de transistor d'amplification (19) sont respectivement liés à au moins un circuit de commande, dans lequel lesdits circuits de commande sont des transistors élémentaires d'une matrice de transistor de commande (13), et dans lequel la liaison est obtenue en connectant au moins un doigt de la matrice de transistor de commande (13) à un doigt de la matrice de transistor d'amplification (19) avec des lignes respectives.

6. Dispositif d'amplification de puissance selon l'une quelconque des revendications 4 et 5, dans lequel des lignes inversées sont associées aux lignes connectant des doigts de la matrice de transistor de commande (13) aux doigts de la matrice de transistor d'amplification (19), dans lequel lesdites lignes reçoivent un signal inversé, et dans lequel les lignes de connexion et les lignes inversées se terminent dans un amplificateur de classe S.

7. Dispositif d'amplification de puissance selon l'une quelconque des revendications 4 à 6, comprenant en outre des filtres à réponse impulsionnelle finie (FIR), configurés pour filtrer le signal des branches respectives (a, b, c).

8. Dispositif d'amplification de puissance selon l'une quelconque des revendications 1 à 7, comprenant en outre une boucle de rétroaction (9) configurée pour adapter le poids d'au moins un amplificateur de puissance (19a, 19b, 19c) afin de contrebalancer la distorsion dans le signal de sortie.

9. Dispositif d'amplification de puissance selon l'une quelconque des revendications 1 à 6, dans lequel les amplificateurs de puissance (19a, 19b, 19c) sont connectés à des lignes de retard respectives (35) pour découpler leurs signaux respectifs.

10. Procédé pour amplifier un flux multibit numérique codé sur une pluralité de flux de bits, comprenant les étapes suivantes
- les flux de bits sont délivrés à des chaînes d'amplification de puissance bistables indépendantes,
- une pluralité de bits de poids le plus faible (LSB) est multiplexée sur le flux de bits connecté à la chaîne d'amplification de puissance de poids le plus faible,
- les chaînes d'amplification de puissance respectives amplifient les flux de bits dans un signal analogique amplifié de puissance élevée, avec une puissance proportionnelle à un poids relatif de la chaîne d'amplification de puissance choisi de sorte que la somme des poids des chaînes d'amplification de puissance d'émission pour chaque valeur multibit soit différente de la somme des poids des chaînes d'ampiification de puissance d'émission pour les autres valeurs de flux multibit,
- les signaux numériques en sortie des chaînes d'amplification de puissance sont combinés pour obtenir le signal de sortie analogique amplifié.

11. Procédé selon la revendication 10, comprenant en outre l'étape suivante
- la valeur de poids relatif d'au moins une chaîne d'amplification est ajustée par conception conformément à la distorsion de puissance mesurée en sortie.

12. Procédé selon la revendication 10 ou 11, dans lequel la chaîne d'amplification de puissance de poids le plus fort code le bit de poids le plus fort (MSB).

13. Procédé selon l'une quelconque des revendications 10 à 12, dans lequel la chaîne d'amplification de puissance de poids le plus faible code le bit de poids le plus faible (LSB).
